# EUROPEAN PATENT SPECIFICATION

(11) **EP 1 352 548 B1**
(45) Date of publication and mention of the grant of the patent: **12.04.2006**
(21) Application number: 01270087.8
(22) Date of filing: 10.12.2001
(51) Int. Cl.: H05K 3/00, H05K 3/10

(54) **METHOD OF FORMING ELECTRICALLY CONDUCTIVE ELEMENTS AND PATTERNS OF SUCH ELEMENTS**
VERFAHREN ZUM AUSBILDEN VON ELEKTRISCH LEITENDEN ELEMENTEN UND MUSTER SOLCHER ELEMENTE
PROCEDE DE FORMATION D'ELEMENTS ELECTROCONDUCTEURS ET MOTIFS FORMES PAR CES ELEMENTS

(30) Priority: 09.12.2000 GB 0030095
(43) Date of publication of application: 15.10.2003
(73) Proprietor: Xaar Technology Limited, Cambridge CB4 0XR (GB)
(72) Inventor: BAKER-SMITH, Hugh, Bramley, Hampshire RE26 5AX (GB); KINGS, Donald, Newport, Essex CB11 3QF (GB); TATUM, John, Isleham, Ely CB7 5RY (GB)
(74) Representative: Garratt, Peter Douglas
(86) International application number: PCT/GB2001/005442
(87) International publication number: WO 2002/047447

(56) References cited:
- WO-A-89/05567
- WO-A-99/19900
- WO-A-99/53738
- CH-A- 673 920
- FR-A- 2 718 142
- US-A- 4 485 387

## Description

The present invention relates to the formation of electrically conductive elements - such as those employed in printed circuit boards - and in an important example to methods of forming a printed pattern of conductive elements using droplet deposition apparatus.

Droplet deposition apparatus come in many forms and styles. One common form of droplet deposition apparatus is that known in the art as an inkjet print head. Inkjet print heads are capable of ejecting a liquid (which is referred to as "ink" whether it is coloured or colourless) which may perform a function other than simply forming a visual image. In particular the deposited liquids may contain biological material for use in assays; perfumes; electrically conductive particles or a variety of other elements that perform a function beyond that of forming an image.

One of the many benefits of droplet deposition apparatus is the ability to deposit droplets of liquid onto a substrate with great accuracy see for example document WO-A-9919900. The accuracy or resolution of such apparatus is partly determined by the fineness of the droplet deposition nozzle and inkjet print heads may typically have nozzles that are below 50 µm in diameter. This means of course that the physical properties of deposition liquids need to be tightly controlled in order to ensure that ejection is reliably performed through such fine nozzles. Deposition liquids need to have a low viscosity, preferably not greater than 35mPas at 30°C, and other constraints such as surface tension, particle size, conductivity and stability amongst other things also need to be taken into consideration when formulating a deposition liquid. It is difficult to formulate deposition liquids that will satisfy every one of these constraints especially where a special function is required by the liquid e.g. drying to form a conductive track.

It is known in the prior art that a droplet deposition apparatus can be used to manufacture printed circuit boards (PCBs). Typically, these PCBs are single layer and are formed by the printhead depositing a resist coating which is used to cover a conductive layer. The PCB is then acid-etched to remove metal from all uncoated areas. The resist is then removed to leave the metal tracks.

It would be convenient to eliminate the acid etching step.

A difficulty with the direct deposition of electrically conductive ink, is that the high loading of conductive particles that is generally required to provide a conductive track of very low resistance, tends to increase the viscosity of the deposition liquid to a point where deposition through fine nozzles is very difficult if not impossible.

A further constraint that needs to be considered arises from the properties of the PCB substrate. It is desirable in the manufacture of PCB's, as with most printing applications, that patterns are formed that are well defined i.e. with little or no bleeding at the edges of the print. Electrically conductive tracks are usually formed on PCB's at high density and there is a real risk of shorting if the deposition liquid is liable to bleed and especially if there is lateral spread of deposition liquid on the substrate in directions perpendicular to the direction in which the track extends. In general printing processes, techniques to avoid bleeding of ink often rely on the absorption of ink into the media itself, to prevent lateral movement. PCB substrates are typically impermeable and this mechanism to prevent lateral spread of deposition liquid is therefore not available.

It is an object of one aspect of the present invention to address the problem of forming electrically conductive elements on - for example - PCB's by taking advantage of the useful characteristics of droplet deposition apparatus.

Accordingly, the present invention consists in one aspect in a method of forming an elongate electrically conductive element on a planar substrate from a liquid that dries to form said elongate conductive element, said liquid being deposited from a device spaced apart from said substrate and wherein a barrier located on said planar substrate impedes spreading of said liquid in at least one horizontal direction perpendicular to the direction of elongation of said elongate conductive element.

The barrier is preferably formed in a droplet deposition process. Advantage is therefore taken of the accuracy and high resolution of droplet deposition apparatus, unencumbered by high particulate loading of the deposited liquid.

In a first and preferred embodiment the barrier stands proud of the surface of the substrate. The conductive liquid is deposited adjacent the barrier and is thus prevented from spreading. The conductive liquid may be deposited through droplet deposition apparatus, but since the lateral extent of the track is determined by the barrier, this conductive liquid may be deposited through relatively thick nozzles with much greater tolerance on viscosity and particulate loading levels.

The substrate may be any appropriate, non-conductive material. Preferably the non-conductive liquid can be used to form raised walls and associated channels into which the conductive liquid is deposited. The depth of the channels may range from 2-3 µm to 1-2mm depending on the form of the walls and on the application.

To build higher barriers or walls it is preferable that the deposition liquid is a phase-change liquid i.e. it can be treated to form a non liquid surface. Appropriate liquids are those that are known as hot-melt inks which are typically fluids that are liquid when ejected at a temperature around 100°C and "freeze" when allowed to cool below this temperature. Other suitable deposition liquids are those that undergo a phase change when subjected to electromagnetic radiation such as UV light.

UV curing deposition liquids are particularly preferred as it has been found that partially curing the deposition liquids provides a surface that offers good adhesion to any subsequently printed layers. Thus it becomes possible to re-print another layer of deposition liquid onto previously partially cured deposition liquid to form walls of a greater depth, up to 1-3mm in height. Each of the layers or sub patterns can have different topographical features which makes it possible to create three dimensional wall structures of particular shape and, especially, ramps of different sizes or angles.

As mentioned earlier, conductive liquid is deposited between the formed walls to form the conductive tracks. As the non-conductive walls impede the spreading of the conductive deposition liquid, and thus the potential for short circuits, a significantly greater amount of the conductive deposition liquid can be deposited to improve the efficiency of the printed track. Preferably the conductive liquid extends up the wall between 20% and 85% of the wall height though, it is of course possible to deposit the liquid up to the height of the wall.

Preferably, the walls are formed by ejecting ink from a drop on demand ink jet print head and even more preferably a piezoelectric drop on demand ink jet print head. Thus, because the walls have been deposited accurately from a inkjet print head there is less requirement for accuracy from the method of depositing the conductive tracks. Provided the liquid used to form the tracks does not fall outside the grooves formed by the non-conductive walls then there is no danger of short circuits. Appropriate non contact methods of depositing the liquid to form the tracks are extrusion, pipetting or inkjet printing amongst others.

An optional further coating of a non conductive liquid can be applied over the conductive track in order to provide a protective layer or to allow for a second further layer of conductive tracks to be applied over the first layer according to a second aspect of the present invention.

It is well known that it is more efficient for electrical tracks to change direction through two 45° angles rather than a single 90° angle. In a similar manner, it is beneficial to join multiple layers in a printed circuit board through a non 90° angle and preferably through an obtuse angle to the plane of the substrate.

The image can comprise walls akin to those in the first embodiment to contain the conductive deposition liquid applied to the second layer.

In a further embodiment of the present invention, the barrier layer comprises an image formed of a material having a surface energy lower than that of the substrate. This has the effect of causing the conductive liquid to form a high contact angle at the substrate / barrier layer interface and correspondingly impedes the conductive liquid.

The present invention will now be described by way of example only with reference to the accompanying drawings in which:-
Figure 1 is a top view of a PCB substrate printed with a first pattern;
Figure 2 shows a section through the substrate along line A-A;
Figure 3 shows the pattern of figure 1 after a second pattern has been deposited;
Figure 4 is a top view of a PCB substrate of figure 3 printed with a third pattern
Figure 5 is a section view through line A-A of figure 4 after deposition of a fourth pattern
Figure 6 is a section view through line B-B of figure 4 after deposition of a fourth pattern
Figures 7 to 11 are section views showing the stages of building up a connection between layers in a multilayer PCB
Figures 12 and 13 are section views of an alternative embodiment.

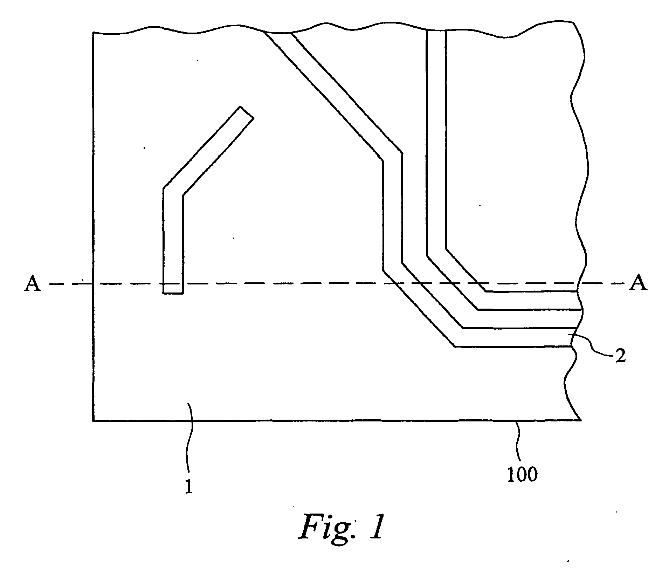

Figure 1 shows a substrate 100 onto which a pattern has been formed. The substrate 100 is a rigid component formed of polymeric or other plastic materials typically used to manufacture PCBs. The first pattern 1 is printed onto the substrate using a 100% reactive UV curable ink to form a raised three dimensional pattern, leaving grooves 2. Often, this raised pattern can be formed with a single pass of the printhead, however, sometimes multiple passes are required in order to achieve the desired effect. Where multiple passes are required it is desirable to partially cure each level prior to deposition of the next layer.

An ink of this sort is described in WO 99/29787. A specific, but non limiting example taken from the application is a black ink comprising :

| | |
|---|---|
| Actilane 430 | 10 wt% |
| Actilane 251 | 10 wt% |
| Tegorad 2200 | 0.4 wt% |
| Isobornyl Acrylate | 39.7 wt% |
| Speedcure ITX | 2.0 wt% |
| Quantacure EHA | 3.0 wt% |
| Irgacure 907 | 5.0 wt% |
| Regal 250R | 1.5 wt% |
| Solsperse 24000 | 0.38 wt% |
| Solsperse 5000 | 0.03 wt% |

Actilane 430 - trimethylpropane ethoxylate triacrylate
Actilane 251 - trifunctional urethane acrylate prepolymer
Tegorad 2200 - Silicone polyether acrylate
Speedcure ITX - isopropylthioxanthone
Quantacure EHA - -2-ethylhexyl p-dimethylaminobenzoate
Irgacure 907 - 2-methyl-1-(4-methylthio)phenyl-2-morpholino-propan-1-one
Regal 250R - carbon black
Solsperse 5000/24000 - hyperdispersants

The diluent consists essentially of reactive liquid material and, optionally, at least one photopolymerisation catalyst and wherein the reactive liquid material comprises monofunctional, difunctional and tri- or higher functional material and wherein the total amount of tri- or higher functional material forms more than 10 but not more than 30 wt% of the total amount of the reactive material, the total amount of monofunctional material forms at least 20 wt% of the total amount of reactive material, and the total amount of difunctional material forms at least 17.5 wt% of the total amount of the reactive material and is such that the total amount of di- or higher functional material is not less than 35 wt%.

The quality of a pattern printed from an inkjet print head using UV curable deposition liquid can be improved if an undercoat or receiver layer is subjected to a partial cure prior to the deposition of one or more top layers. Partially curing the receiver layer provides a surface that has good wetting and adhesive properties while still allowing for the uniform spreading of drops.

Partial curing may be used once or a number of times during the production of a pattern. Each layer may be partially cured prior to the addition of a subsequent layer or a number of layers can be applied and then partially or fully cured. Partial cure is achieved by subjecting the deposited liquid to a lower cure energy than that required to fully cure the ink. In this example the ink was partially cured using a cure energy of 0.1J/cm² and fully cured using a cure energy of the order 0.7J/cm².

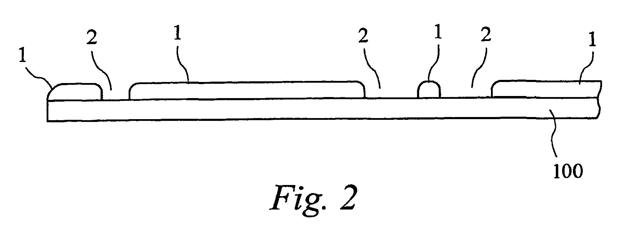

The first pattern is used to define the edges of the electrical track and therefore grooves 2 are provided either by leaving the area unprinted or by depositing less deposition liquid. Figure 2 is a sectional view through the line A-A. Whilst it is shown that the first pattern extends to the edge of the edge of the substrate there are instances where it is desirable just to deposit enough deposition liquid to define the grooves 2.

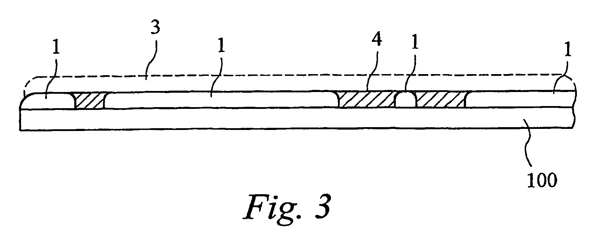

A conductive deposition liquid 4 is deposited onto the substrate in a pattern corresponding to the grooves formed by the first pattern as shown in figure 3. The first pattern 1 prevents the deposition liquid deposited in this second pattern from spreading sideways and forming a short circuit with adjacent tracks. The second deposition liquid should be conductive, the conductivity being imparted by metallic particles within the deposition liquid. This second deposition liquid is allowed to dry to form the conductive tracks of the printed circuit board.

It is desirable - even in a single layer printed circuit board - to protect the tracks 4 by depositing a further protective layer 3 over the top of the first two patterns deposited. This third pattern is non-conductive to prevent short circuits and preferably is of the same formulation as the deposition liquid used to deposit the first pattern. The curable deposition liquids are fully cured at this point to form a hard gloss type coating.

Certain sections of the first two patterns corresponding to the placement of electrical components (not shown) or further electrical tracks can be deliberately left unprinted by the protective layer 3. Connection of the electrical components can then be made using conventional equipment.

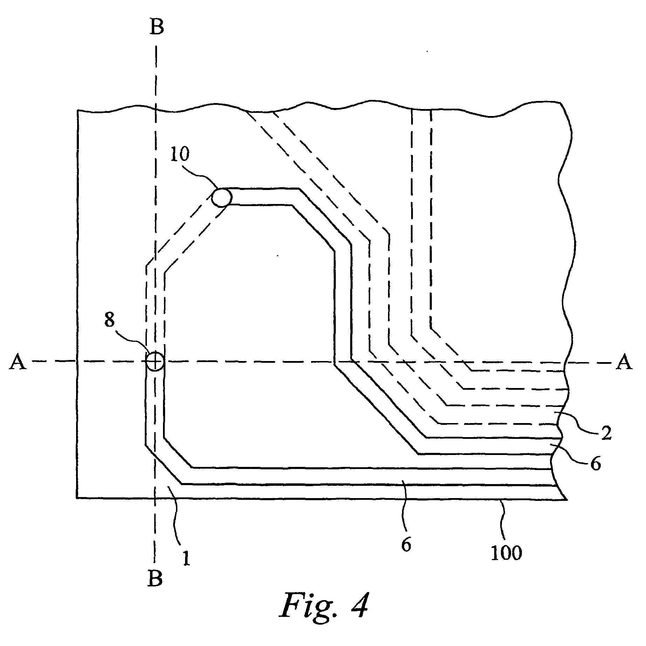

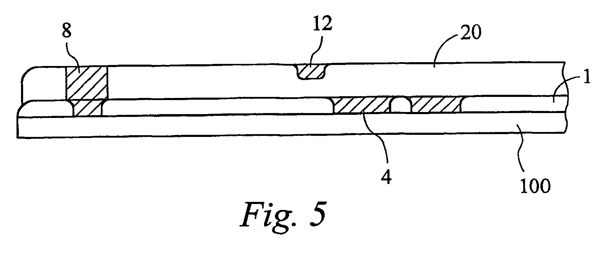

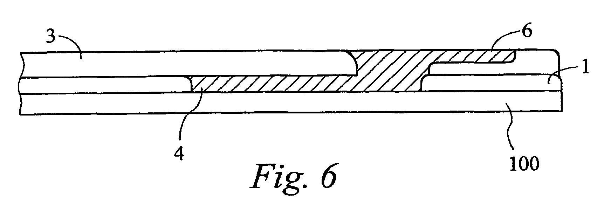

In figure 5, a sectional view along the line A-A of figure 4, the protective layer 20 defines further grooves and is formed with unprinted areas at points 8 and 10. In a subsequent step points 8 and 10 are filled with conductive deposition liquid that contacts the earlier deposited conductive tracks 4 and forms an electrical connection. The formed tracks 12 are insulated from the tracks 4 formed in the first layer by dint of the insulating layer 20. It is only at point 8 where the desired connection between the two conducting layers is formed. Figure 6 is a sectional view along line B-B of figure 4 and shows the connection of the lower first track 4 and the upper second track 6

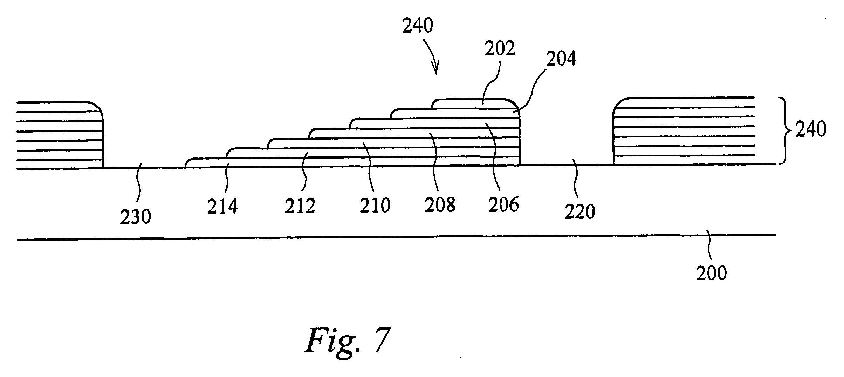

As mentioned earlier the non-conductive deposition liquid can be deposited in a plurality of layers to build the three dimensional profile into which the conductive deposition liquid is deposited. Figures 7 to 11 exemplify the preferred method of forming the electrical connection between the conductive layers in a multilayer circuit board.

A first barrier pattern 240 is deposited onto a substrate 200 using a droplet deposition device. The three dimensional pattern is formed during a number of passes of the printhead and the individual layers 202, 204, 206, 208, 210, 212, 214 are formed during each pass; each layer is of smaller area than the preceding layer. Each pass is subjected to a partial cure prior to the deposition of the next layer. Unprinted areas 230,220 are bounded on either side by the first pattern 240.

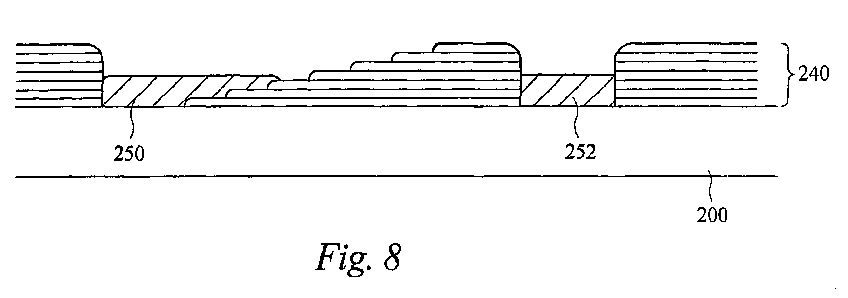

Conductive deposition liquid 250 is then deposited into these unprinted areas as shown in figure 8. The amount of deposition liquid deposited typically provides a pattern that is less than the height of the first pattern 240. The profiled nature of the first pattern caused by the layers 202-214 allows the conductive deposition liquid, provided it is deposited in sufficient quantity, to flow and overlap one or more of the lower layers 214,212 of the first pattern to form a larger area and which facilitates electrical connection. In this example, the partially cured layers 202-214 provide good surface qualities which will allow the conductive deposition liquid to be deposited directly on to the profiled pattern. Beneficially the this allows for a reduced number of deposition steps and overcomes any difficulties that may arise because of surface properties of the non conductive liquid.

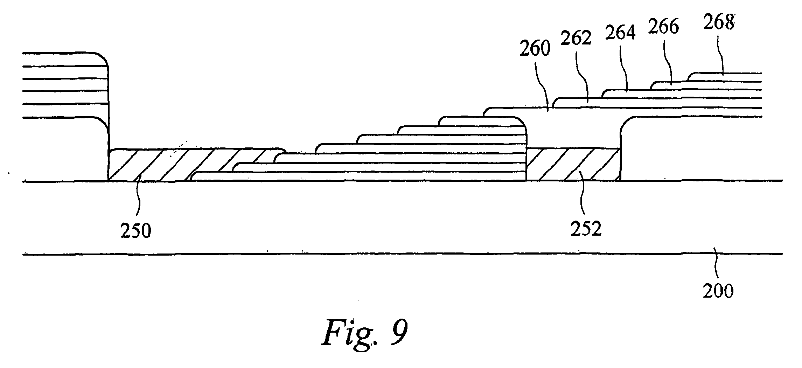

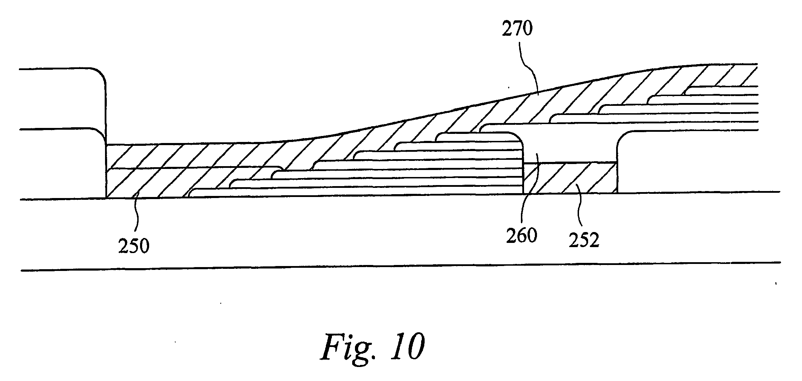

As shown in figure 9 a further layer of non-conductive deposition liquid is deposited in consecutive layers 260-268. The conductive deposition liquid at 252 is covered with the non-conductive deposition liquid layers 260-268 which are subjected to a curing step. A portion of the conductive deposition liquid is not overprinted with the further layers of non-conductive deposition liquid 260-268 to allow electrical connection to further deposited conductive deposition liquid tracks as shown in figure 10.

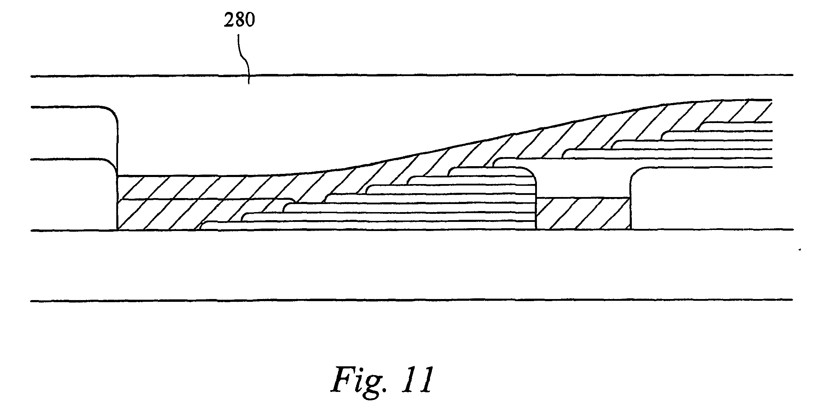

The deposition liquid at 252 is insulated from the later deposited conductive deposition liquid 270 by virtue of the pattern formed using the non-conductive deposition liquid 260. Finally, figure 11, a protective layer 280 of non-conductive deposition liquid is deposited over the entire surface and all the patterns are subjected to a cure stage to cure the curable deposition liquids.

The angled connection between the layers improves the efficiency of the connection between the layers. The circuit board depicted in figure 4 shows that it is possible, as the track moves away from the substrate, to alter its direction within the layers. Thus, the angle of the track as it moves from a lower to an upper layer, when viewed from above, need not be parallel with either the tracks in either of the layers. It is, however, desirable though not essential to have the angle of the slope, when viewed from above, to be parallel with at least one of upper or lower tracks.

For efficiency purposes it is desirable that any change in direction does not have the configuration of an acute angle.

It is of course possible to print further layers provided that the board continues to allow for the securing of the electrical components such as transistors, resistors and the like. These may be secured using conventional methods.

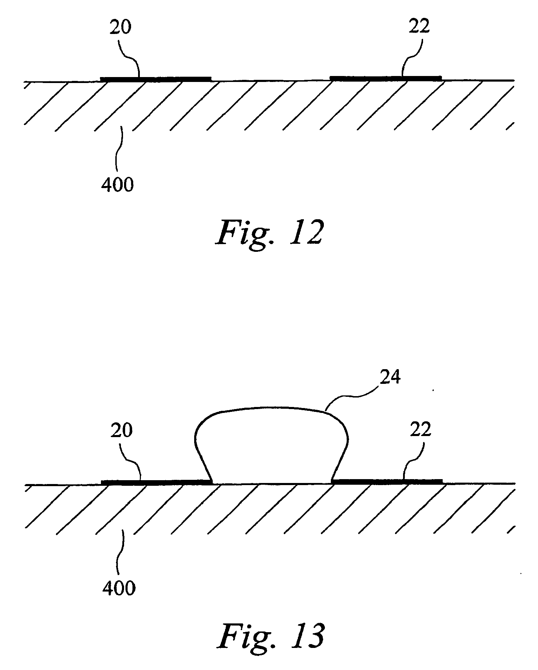

A second embodiment of the present invention is described with respect to figures 12 and 13. A substrate 400 is provided onto which a first barrier pattern is printed 20,22. The barrier pattern is preferably printed using an deposition liquid which dries to form a non-wetting surface. A second pattern 24 is then deposited using a conductive deposition liquid or more preferably an deposition liquid that dries to form a conductive track.

As shown in figure 13, the non wetting pattern 20,22 causes the conductive deposition liquid to form a high contact angle at the interface between the substrate not printed with the non-wetting deposition liquid and the substrate printed with the non-wetting deposition liquid. This prevents the conductive deposition liquid 24 from spreading as far along the substrate as when the non-wetting pattern 20,22 had not been deposited. Thus the frequency of electrical shorts between neighboring tracks can be reduced.

Whilst the invention has been described with respect of using UV curable deposition liquids, other types of deposition liquids e.g. hot melt or phase change deposition liquids are equally applicable.

## Claims

1. Method of forming an elongate conductive element on a planar substrate (100) from a liquid that dries to form said elongate conductive element (4), said liquid being deposited from a device spaced apart from said substrate and wherein a barrier (1) located on said planar substrate impedes spreading of said liquid in at least one horizontal direction perpendicular to the direction of elongation of said elongate conductive element and wherein said barrier is formed by material deposited drop by drop.

2. Method according to Claim 1, wherein said device depositing said liquid is a droplet deposition apparatus.

3. Method according to Claim 2, wherein said device is an inkjet print head.

4. Method according to Claim 2, wherein said device is a pipette.

5. Method according to any preceding claim, wherein said barrier stands proud of the surface of said planar substrate.

6. Method according to any preceding claim, wherein said barrier material is deposited by a droplet deposition apparatus.

7. Method according to any of the preceding claims, wherein said barrier undergoes a partial or full phase change step to a solid whilst on said substrate.

8. Method according to Claim 6 or Claim 7, wherein said barrier is deposited in a plurality of layers, one or more of said plurality of layers undergoing said phase change step prior to the deposition a subsequent layer.

9. Method according to Claim 8 wherein said phase change step is achieved by subjecting said liquid to electromagnetic radiation.

10. Method according to Claim 9, wherein said electromagnetic radiation is ultraviolet light.

11. Method according to any one of Claims 7 to 10 wherein said phase change step is achieved by subjecting said liquid to a temperature change.

12. Method according to any one of Claims 1 to 4, wherein said barrier is formed as a pattern of material having a lower surface energy than said substrate.

13. Method of forming a pattern on a substrate comprising the steps: forming a three dimensional first pattern (1) on said substrate (100) using a non-conductive first liquid, and subsequently, depositing an electrically conductive second pattern having one or more elongate portions (4) on said substrate using a second liquid; wherein said second liquid (4) is impeded from spreading in at least one horizontal direction perpendicular to said elongate portions by said first pattern (1) and wherein one or both of said patterns are deposited by a droplet deposition apparatus.

14. Method according to Claim 13, wherein said first non-conductive liquid is deposited from an inkjet print head passing over said substrate.

15. Method according to Claim 14, wherein said inkjet print head deposits said first non-conductive liquid onto said substrate from a plurality of passes over said substrate forming a plurality of sub first patterns.

16. Method according to Claim 15, wherein one or more of said plurality of sub first patterns are topographically different.

17. Method according to Claim 15 or Claim 16, wherein one or more of said plurality of sub first patterns are treated to have a non liquid surface prior to the formation of a subsequent sub first pattern.

18. Method according to Claim 17, wherein said treatment comprises the step of exposing said one or more of said plurality of sub first patterns to ultraviolet light.

19. Method according to any one of Claim 13 to Claim 18, wherein said first pattern is printed such that it extends vertically from said substrate forming elongate grooves having walls.

20. Method according to Claim 19, wherein said second liquid is printed into said grooves.

21. Method according to Claim 20, wherein said second liquid is deposited in a quantity sufficient to extend 20% the height of said walls.

22. Method according to any one of Claim 13 to Claim 21, wherein said second liquid is deposited from an inkjet print head.

23. Method according to any one of Claim 13 to Claim 21, wherein said second liquid is deposited from a pipette.

24. Method according to any one of Claim 13 to Claim 23 comprising a further step wherein a non-conductive third liquid is deposited over said first pattern and said second pattern in a third pattern.

## Revendications

1. Procédé de formation d'un élément conducteur allongé sur un substrat plan (100) à partir d'un liquide qui sèche pour former ledit élément conducteur allongé (4), ledit liquide étant déposé à partir d'un dispositif placé à l'écart dudit substrat et dans lequel une barrière (1) localisée sur ledit substrat plan gène la diffusion dudit liquide dans au moins une direction horizontale perpendiculaire à la direction d'allongement dudit élément conducteur allongé et dans lequel ladite barrière est formée par un matériau déposé goutte à goutte.

2. Procédé selon la revendication 1, dans lequel ledit dispositif déposant ledit liquide est un appareil de déposition de gouttelettes.

3. Procédé selon la revendication 2, dans lequel ledit dispositif est une tête d'impression à jet d'encre.

4. Procédé selon la revendication 2, dans lequel ledit dispositif est une pipette.

5. Procédé selon l'une quelconque des revendications précédentes, dans lequel ladite barrière dépasse de la surface dudit substrat plan.

6. Procédé selon l'une quelconque des revendications précédentes, dans lequel ledit matériau barrière est déposé par un appareil de déposition de gouttelettes.

7. Procédé selon l'une quelconque des revendications précédentes, dans lequel ladite barrière subit une étape de changement de phase partielle ou totale en un solide pendant qu'elle est sur ledit substrat.

8. Procédé selon la revendication 6 ou la revendication 7, dans lequel ladite barrière est déposée en une pluralité de couches, une ou plusieurs de ladite pluralité de couches subissant ladite étape de changement de phase avant la déposition d'une couche ultérieure.

9. Procédé selon la revendication 8, dans lequel ladite étape de changement de phase est réalisée en exposant ledit liquide à un rayonnement électromagnétique.

10. Procédé selon la revendication 9, dans lequel ledit rayonnement électromagnétique est le rayonnement ultraviolet.

11. Procédé selon l'une quelconque des revendications 7 à 10, dans lequel ladite étape de changement de phase est réalisée en exposant ledit liquide à un changement de température.

12. Procédé selon l'une quelconque des revendications 1 à 4, dans lequel ladite barrière est formée comme un motif d'un matériau ayant une énergie de surface plus faible que ledit substrat.

13. Procédé de formation d'un motif sur un substrat comprenant les étapes consistant à :
former un premier motif tridimensionnel (1) sur ledit substrat (100) en utilisant un premier liquide non conducteur, et par la suite, déposer un second motif électroconducteur ayant une ou plusieurs parties allongées (4) sur ledit substrat en utilisant un second liquide ; dans lequel ledit second liquide (4) est gêné dans sa diffusion dans au moins une direction horizontale perpendiculaire auxdites portions allongées par ledit premier motif (1) et dans lequel un ou plusieurs desdits motifs sont déposés par un appareil de déposition de gouttelettes.

14. Procédé selon la revendication 13, dans lequel ledit premier liquide non conducteur est déposé à partir d'une tête d'impression à jet d'encre passant au-dessus dudit substrat.

15. Procédé selon la revendication 14, dans lequel ladite tête d'impression à jet d'encre dépose ledit premier liquide non conducteur sur ledit substrat à partir d'une pluralité de passages sur ledit substrat en formant une pluralité de sous premiers motifs.

16. Procédé selon la revendication 15, dans lequel un ou plusieurs de ladite pluralité de sous premiers motifs sont topographiquement différents.

17. Procédé selon la revendication 15 ou la revendication 16, dans lequel un ou plusieurs de ladite pluralité de sous premiers motifs sont traités pour avoir une surface non liquide avant la formation d'un sous premier motif ultérieur.

18. Procédé selon la revendication 17, dans lequel ledit traitement comprend l'étape consistant à exposer lesdits un ou plusieurs de ladite pluralité de sous premiers motifs au rayonnement ultraviolet.

19. Procédé selon l'une quelconque des revendications 13 à la revendication 18, dans lequel ledit premier motif est imprimé de sorte qu'il s'étende verticalement à partir dudit substrat formant des sillons allongés ayant des parois.

20. Procédé selon la revendication 19, dans lequel ledit second liquide est imprimé dans lesdits sillons.

21. Procédé selon la revendication 20, dans lequel ledit second liquide est déposé en une quantité suffisante pour allonger de 20% la hauteur desdites parois.

22. Procédé selon l'une quelconque des revendications 13 à 21, dans lequel ledit second liquide est déposé à partir d'une tête d'impression à jet d'encre.

23. Procédé selon l'une quelconque des revendications 13 à 21, dans lequel ledit second liquide est déposé à partir d'une pipette.

24. Procédé selon l'une quelconque des revendications 13 à 23 comprenant une étape supplémentaire dans laquelle un troisième liquide non conducteur est déposé sur ledit premier motif et ledit second motif en un troisième motif.

## Patentansprüche

1. Verfahren zum Ausbilden eines ausgedehnten leitenden Elements auf einem ebenen Substrat (100) aus einer Flüssigkeit, welche trocknet, um damit das ausgedehnte leitende Element (4) auszubilden, wobei die Flüssigkeit von einer Vorrichtung abgeschieden wird, welche mit Zwischenraum von dem Substrat getrennt angeordnet ist, und bei welchem eine Sperrschicht (1), welche auf dem ebenen Substrat befindlich ist, das Ausbreiten der Flüssigkeit in wenigstens einer horizontalen Richtung, senkrecht zur Richtung der Ausdehnung des ausgedehnten, leitenden Elementes verhindert, und bei welchem die Sperrschicht durch ein Material ausgebildet wird, welches Tropfen für Tropfen abgeschieden wird.

2. Verfahren gemäß Anspruch 1, bei welchem die Vorrichtung, welche die Flüssigkeit abscheidet, ein Tröpfchen-Abscheidungs-Gerät ist.

3. Verfahren gemäß Anspruch 2, bei welchem die Vorrichtung ein Tintenstrahl-Druckkopf ist.

4. Verfahren gemäß Anspruch 2, bei welchem die Vorrichtung eine Pipette ist.

5. Verfahren gemäß irgendeinem der vorangegangenen Ansprüche, bei welchem die Sperrschicht aus der Oberfläche des ebenen Substrats herausragend steht.

6. Verfahren gemäß irgendeinem der vorangegangenen Ansprüche, bei welchem das Sperrschicht-Material durch ein Tröpfchen-Abscheidungs-Gerät abgeschieden wird.

7. Verfahren gemäß irgendeinem der vorangegangenen Ansprüche, bei welchem die Sperrschicht einen teilweisen oder vollständigen Phasenumwandlungsschritt zu einem festen Körper durchmacht, während sie sich auf dem Substrat befindet.

8. Verfahren gemäß Anspruch 6 oder Anspruch 7, bei welchem die Sperrschicht in einer Vielzahl von Schichten abgeschiedenen wird, wobei eine oder mehrere der Vielzahl von Schichten den Phasenumwandlungsschritt vor dem Abscheiden einer nachfolgenden Schicht durchmacht bzw. durchmachen.

9. Verfahren gemäß Anspruch 8, bei welchem der Phasenumwandlungsschritt erreicht wird, indem die Flüssigkeit einer elektromagnetischen Strahlung ausgesetzt wird.

10. Verfahren gemäß Anspruch 9, bei welchem die elektromagnetische Strahlung ultraviolettes Licht ist.

11. Verfahren gemäß irgendeinem der Ansprüche 7 bis 10, bei welchem der Phasenumwandlungsschritt erreicht wird, indem die Flüssigkeit einem Temperaturwechsels unterworfen wird.

12. Verfahren gemäß irgendeinem der Ansprüche 1 bis 4, bei welchem die Sperrschicht als ein Muster eines Materials ausgebildet ist, welches eine geringere Oberflächenenergie bzw. Grenzflächenspannung aufweist, als das Substrat.

13. Verfahren zur Ausbildung eines Musters auf einem Substrat, welches folgende Schritte umfasst: Ausbilden eines dreidimensionalen ersten Musters (1) auf dem Substrat (100), wobei eine nicht leitende erste Flüssigkeit verwendet wird, und anschließend Abscheiden eines elektrisch leitenden zweiten Musters auf dem Substrat, welches einen oder mehrere ausgedehnte Abschnitte (4) aufweist, wobei eine zweite Flüssigkeit verwendet wird; wobei die zweite Flüssigkeit (4) durch das erste Muster (1) daran gehindert wird, sich in wenigstens eine horizontale Richtung senkrecht zu den ausgedehnten Abschnitten auszubreiten, und wobei eines oder beide der Muster durch ein Tröpfchen-Abscheidungs-Gerät abgeschieden werden.

14. Verfahren gemäß Anspruch 13, bei welchem die erste, nicht leitende Flüssigkeit von einem Tintenstrahl-Druckkopf abgeschieden wird, welcher über das Substrat fährt.

15. Verfahren gemäß Anspruch 14, bei welchem der Tintenstrahl-Druckkopf die erste nicht leitende Flüssigkeit auf dem Substrat abscheidet, und zwar von einer bzw. durch eine Vielzahl von Durchläufen über das Substrat, wobei eine Vielzahl von ersten Untermustern ausgebildet werden.

16. Verfahren gemäß Anspruch 15, bei welchem eines oder mehrere der Vielzahl von ersten Untermustern topografisch unterschiedlich ist bzw. sind.

17. Verfahren gemäß Anspruch 15 oder Anspruch 16, bei welchem eines oder mehrere der Vielzahl von ersten Untermustern so behandelt werden, um eine nicht flüssige Oberfläche aufzuweisen, und zwar vor der Ausbildung eines nachfolgenden ersten Untermusters.

18. Verfahren gemäß Anspruch 17, bei welchem die Behandlung den Schritt des Belichtens des einen oder mehrerer der Vielzahl von ersten Untermustern mit ultraviolettem Licht umfasst.

19. Verfahren gemäß irgendeinem der Ansprüche 13 bis 18, bei welchem das erste Muster so gedruckt wird, dass es sich vertikal vom Substrat ausdehnt, wobei ausgedehnte Rillen ausgebildet werden, welche Wälle aufweisen.

20. Verfahren gemäß Anspruch 19, bei welchem die zweite Flüssigkeit in die Rillen gedruckt wird.

21. Verfahren gemäß Anspruch 20, bei welchem die zweite Flüssigkeit in einer Menge abgeschieden wird, welche genügt, um die Höhe der Wälle um 20% auszudehnen.

22. Verfahren gemäß irgendeinem der Ansprüche 13 bis 21, bei welchem die zweite Flüssigkeit von einem Tintenstrahl-Druckkopf abgeschieden wird.

23. Verfahren gemäß irgendeinem der Ansprüche 13 bis 21, bei welchem die zweite Flüssigkeit von einer Pipette abgeschieden wird.

24. Verfahren gemäß irgendeinem der Ansprüche 13 bis 23, welches einen weiteren Schritt aufweist, bei welchem eine nicht leitende dritte Flüssigkeit über das erste Muster und das zweite Muster in ein drittes Muster abgeschieden wird.
